# EUROPÄISCHE PATENTSCHRIFT

(11) **EP 2 794 349 B1**
(45) Veröffentlichungstag und Bekanntmachung des Hinweises auf die Patenterteilung: **08.07.2020**
(21) Anmeldenummer: 12812243.9
(22) Anmeldetag: 20.12.2012
(51) Int. Cl.: B60Q 1/14, H03K 17/955, H03K 17/96

(54) **BERÜHRUNGS- UND/ODER ANNÄHERUNGSSENSITIVE BEDIENEINRICHTUNG FÜR EIN KRAFTFAHRZEUG UND KRAFTFAHRZEUG**
TOUCH OR PROXIMITY SENSITIVE OPERATING DEVICE FOR A MOTOR VEHICLE AND MOTOR VEHICLE
DISPOSITIF DE COMMANDE À CAPTEUR D'EFFLEUREMENT OU DE PROXIMITÉ DESTINÉ À UN VÉHICULE AUTOMOBILE, ET VÉHICULE AUTOMOBILE

(30) Priorität: 24.12.2011 DE 102011122399; 06.03.2012 DE 102012004636
(43) Veröffentlichungstag der Anmeldung: 29.10.2014
(73) Patentinhaber: Valeo Schalter und Sensoren GmbH, 74321 Bietigheim-Bissingen (DE)
(72) Erfinder: KAISER, Frank, 74321 Bietigheim-Bissingen (DE); STAUDE, Sascha, 71638 Ludwigsburg (DE); MUELLER, Stefan, 97944 Boxberg (DE)
(74) Vertreter: Pothmann, Karsten
(86) Internationale Anmeldenummer: PCT/EP2012/076349
(87) Internationale Veröffentlichungsnummer: WO 2013/092838

(56) Entgegenhaltungen:
- WO-A1-2008/131190
- DE-B3- 10 331 776
- FR-A1- 2 880 145

## Beschreibung

Die Erfindung betrifft eine berührungs- und/oder annäherungssensitive Bedieneinrichtung für ein Kraftfahrzeug, mit einem länglich ausgeführten Betätigungshebel, insbesondere einem Lenkstockhebel, sowie mit einer Vielzahl von berührungs- und/oder annäherungssensitiven Sensorelementen, welche an dem Betätigungshebel angeordnet sind, wie auch mit einer mit den Sensorelementen gekoppelten elektronischen Auswerteeinrichtung, welche dazu ausgelegt ist, eine Berührung der einzelnen Sensorelemente und/oder eine Annäherung an die einzelnen Sensorelemente zu erfassen. Die Erfindung betrifft außerdem ein Kraftfahrzeug mit einer solchen Bedieneinrichtung.

Das Interesse richtet sich vorliegend insbesondere auf eine kapazitive Bedieneinrichtung, welche eine Vielzahl von kapazitiven Sensorelektroden aufweist, welche Kondensatorplatten jeweiliger Betätigungskondensatoren bilden. Die jeweils zweite Kondensatorplatte wird durch den Finger des Benutzers gebildet. Die Kapazität des Betätigungskondensators ändert sich somit bei einer Berührung bzw. Annäherung an die Sensorelektrode, was durch eine elektronische Auswerteeinrichtung detektiert werden kann. Solche kapazitiven Bedieneinrichtungen sind bereits Stand der Technik. So beschreibt beispielsweise die Druckschrift DE 10 2009 022 471 A1 einen Lenkstockschalter mit einem Schalthebel, an welchem eine Mehrzahl von kapazitiven Sensorelektroden angebracht sind. Über die kapazitive Erfassung der Fingerposition mit den kapazitiven Sensorelektroden können unterschiedlichste Schaltvorgänge bewegungslos erfasst werden.

Die Druckschrift FR 2 880 145 A1 offenbart eine berührungssensitive Bedieneinrichtung mit zwei berührungssensitiven Sensorelemente, die an einem Ende eines länglich ausgeführten Betätigungshebel angeordnet sind.

Es ist Aufgabe der Erfindung, eine Lösung aufzuzeigen, wie die Funktionalität einer Bedieneinrichtung der eingangs genannten Gattung im Vergleich zum Stand der Technik erweitert werden kann.

Diese Aufgabe wird erfindungsgemäß durch eine Bedieneinrichtung sowie durch ein Kraftfahrzeug mit den Merkmalen gemäß den jeweiligen unabhängigen Patentansprüchen gelöst. Vorteilhafte Ausführungen der Erfindung sind Gegenstand der abhängigen Patentansprüche, der Beschreibung und der Figuren.

Eine erfindungsgemäße berührungs- und/oder annäherungssensitive Bedieneinrichtung für ein Kraftfahrzeug weist einen länglich ausgeführten Betätigungshebel, insbesondere einen Lenkstockhebel, auf. Sie umfasst außerdem eine Sensoranordnung mit einer Vielzahl von berührungs- und/oder annäherungssensitiven Sensorelementen, welche an dem Betätigungshebel angeordnet sind. Erfindungsgemäß ist die Vielzahl von Sensorelementen ringförmig in Umfangsrichtung des Betätigungshebels verteilt angeordnet. Die Bedieneinrichtung umfasst auch eine mit der Vielzahl von Sensorelementen gekoppelte elektronische Auswerteeinrichtung, welche dazu ausgelegt ist, eine Berührung der einzelnen Sensorelemente und/oder eine Annäherung an die einzelnen Sensorelemente zu erfassen. Erfindungsgemäß ist es vorgesehen, dass die Auswerteeinrichtung anhand einer Kombination aus zumindest zwei erfassten Berührungen der Sensoranordnung und/oder Annäherungen an die Sensoranordnung eine Bediengeste einer Bedienperson an dem Betätigungshebel erkennt und in Abhängigkeit von der erkannten Bediengeste eine vorbestimmte Bedienfunktion auslöst.

Anders als im Gegenstand gemäß Dokument DE 10 2009 022 471 A1 - dort erfolgt lediglich die Erkennung der Position eines Fingers alleine anhand einer einzigen Berührung - wird somit erfindungsgemäß vorgeschlagen, die Bediengeste der Bedienperson abhängig von einer Kombination von zumindest zwei Berührungen der Sensoranordnung und/oder Annäherungen an die Sensoranordnung zu detektieren. Zur Erkennung der Bediengeste werden somit zumindest zwei Messungen an der Sensoranordnung durchgeführt und im Hinblick auf die Bediengeste der Bedienperson ausgewertet. Dies können einerseits zwei zeitlich versetzte Messungen an einem einzigen Sensorelement oder mehreren Sensorelementen oder aber andererseits zwei - gegebenenfalls auch gleichzeitige - Messungen an mehreren unterschiedlichen Sensorelementen sein. Die Funktionalität bzw. der Einsatzbereich der Bedieneinrichtung wird im Vergleich zum Stand der Technik somit dadurch erweitert, dass anhand der Auswertung einer solchen Kombination aus zumindest zwei Berührungen der Sensoranordnung und/oder Annäherungen an die Sensoranordnung die jeweilige Bediengeste mit hoher Präzision detektiert werden kann, und es können sogar Bedienabsichten der Bedienperson an dem Betätigungshebel im Voraus erkannt werden. Zudem können somit eine Vielzahl von Bediengesten definiert werden, denen jeweils eine andere Bedienfunktion zugeordnet werden kann. Mit lediglich einem einzigen Betätigungshebel, insbesondere einem Lenkstockhebel, können folglich eine ganze Reihe von Bedienfunktionen ausgelöst werden, die ansonsten nur mithilfe mehrerer solcher Betätigungshebel bereitgestellt werden könnten.

Unter einer Bediengeste wird vorliegend insbesondere die Art und Weise verstanden, auf welche die Bedienperson - insbesondere der Fahrer - den Betätigungshebel umgreift. Dieses Umgreifen kann eine spezifische Berührung bzw. ein spezifisches Ertasten des Betätigungshebels mit einem oder mehreren Fingern bedeuten.

Es erweist sich als besonders vorteilhaft, wenn der Betätigungshebel - zum Beispiel Lenkstockhebel - auf zumindest zwei Arten mechanisch bedienbar ist. Dies bedeutet, dass neben der berührungssensitiven Bedienung auch eine mechanische Betätigung des Betätigungshebels möglich ist, sei es eine Bewegung des Betätigungshebels, sei es lediglich die Aufbringung einer Kraft auf den Betätigungshebel und anschließende Detektion mithilfe eines Kraftsensors. Beispielsweise ist der Betätigungshebel in einer horizontalen Richtung - um die Fahrzeughochachse - und/oder in der vertikalen Richtung - um die Fahrzeuglängsachse - schwenkbar gelagert. Der Betätigungshebel kann aber auch entlang seiner eigenen Längsachse gedrückt werden. Er kann auch ein mechanisches Bedienelement aufweisen, welches relativ zu einem Grundkörper des Betätigungshebels bewegt, nämlich beispielsweise gedrückt und/oder gedreht und/oder geschwenkt werden kann. Bei dieser Ausführungsform kann die Auswerteeinrichtung dazu ausgelegt sein, in Abhängigkeit von der detektierten Bediengeste die Art einer bevorstehenden bzw. beabsichtigten mechanischen Bedienung des Betätigungshebels im Voraus zu bestimmen. Dies bedeutet, dass die Auswerteeinrichtung in Abhängigkeit von der Berührung und/oder Annäherung vorhersagen bzw. im Vorfeld bestimmen kann, auf welche Art der Benutzer den Betätigungshebel mechanisch zu betätigen beabsichtigt. Hierbei können beispielsweise folgende Arten der mechanischen Betätigung unterschieden werden:
- eine horizontale Bewegung des Betätigungshebels, nämlich eine Schwenkbewegung um die Fahrzeughochachse, und/oder
- eine vertikale Bewegung des Betätigungshebels, nämlich eine Schwenkbewegung um die Fahrzeuglängsachse, und/oder
- die Betätigung eines Schalters bzw. einer Taste an dem Betätigungshebel, und/oder
- die Betätigung eines Drehschalters, nämlich insbesondere um eine Längsachse des länglich ausgeführten Betätigungshebels.

Dies kann beispielsweise so aussehen, dass ein gleichzeitiges Berühren von drei unterschiedlichen Sensorelementen die Absicht einer Drehbewegung eines Drehschalters signalisiert, während das zeitversetzte Berühren zweier Sensorelemente die Absicht einer Drückbewegung des Betätigungshebels signalisiert. In Abhängigkeit von der detektierten Absicht des Benutzers können dann verschiedenste Aktionen ausgelöst bzw. unterschiedlichste Vorgänge im Kraftfahrzeug bewirkt werden.

Beispielsweise können folgende Ausführungsformen vorgesehen sein: Die Erkennung einer beabsichtigten Betätigung eines Blinkers kann zum Beispiel eine Totwinkelüberwachungseinrichtung aktivieren. Demgegenüber braucht diese nach Erkennen einer beabsichtigten Aktivierung des Fernlichts/Lichthupe nicht aktiviert zu werden. Gemäß einem weiteren Beispiel kann die Erkennung der Absicht, die Empfindlichkeit eines Regensensors oder aber eine Intervallgeschwindigkeit eines Scheibenwischers an einem Wischerhebel zu ändern, dazu führen, dass ein Regensensormenü bzw. ein Intervallmenü auf einer Anzeigeeinrichtung aktiviert wird. Dieses Menü braucht hingegen nach Erkennen der Absicht des Ein- oder Ausschaltens des Scheibenwischers nicht aktiviert zu werden.

Also kann auch vorgesehen sein, dass die Auswerteeinrichtung nach Erkennen der Art der beabsichtigten mechanischen Bedienung eine von einer dieser Art der mechanischen Bedienung zugeordneten Bedienfunktion verschiedene Bedienfunktion auslösen kann. Wie oben bereits ausgeführt kann es sich hierbei um die Aktivierung der Totwinkelüberwachungseinrichtung handeln, wenn ein beabsichtigtes Aktivieren eines Blinkers im Voraus erkannt wird. Somit können bestimmte Fahrerassistenzsysteme noch früher aktiviert werden, und die Sicherheit der Fahrzeuginsassen kann weiterhin gesteigert werden.

Die Auswerteeinrichtung kann dann dazu ausgelegt sein, anhand einer Kombination aus zumindest zwei erfassten (gleichzeitigen oder zeitlich versetzten) Berührungen unterschiedlicher Sensorelemente und/oder Annäherungen an unterschiedliche Sensorelemente die Bediengeste zu erkennen. Die zumindest zwei Berührungen und/oder Annäherungen beziehen sich bei dieser Ausführungsform also auf unterschiedliche Sensorelemente, so dass die Bediengeste anhand einer Kombination aus (gleichzeitigen oder zeitversetzten) Berührungen zumindest zweier Sensorelemente und/oder Annäherungen an zumindest zwei Sensorelemente bestimmt wird. Hierdurch kann die Erkennung der Bediengeste noch präziser erfolgen.

Die Auswerteeinrichtung kann dabei die - im Wesentlichen - gleichzeitige Berührung einer vorbestimmten Kombination aus einzelnen Sensorelementen und/oder die gleichzeitige Annäherung an diese Kombination der Sensorelemente erfassen und abhängig davon die Bediengeste erkennen. Hier wird also die statische Kombination der Sensorelemente erkannt, welche durch den Benutzer betätigt werden. Somit können mit nur wenigen Sensorelementen und mit ein und demselben Betätigungshebel eine Vielzahl von unterschiedlichsten Funktionen ausgelöst werden. Eine Kombination liegt beispielsweise dann vor, wenn eine Annäherung oder Berührung einer Untergruppe bzw. Untermenge der Sensorelemente zu einem Zeitpunkt oder aber innerhalb eines vorgegebenen Zeitintervalls detektiert wird. Eine Plausibilisierung kann hier in der Weise vorgenommen werden, dass diese Kombination für eine situationsabhängig definierte Zeitdauer erkannt werden soll.

Ergänzend oder alternativ kann die Auswerteeinrichtung auch dazu ausgelegt sein, eine zeitliche Reihenfolge der Berührung der einzelnen Sensorelemente und/oder Annäherung an die einzelnen Sensorelemente zu erfassen und in Abhängig von der Reihenfolge die Bediengeste zu erkennen. Hier erfolgt die Erkennung eines bestimmten dynamischen Bewegungsablaufs an den Sensorelektroden. Somit werden der Einsatzbereich und die Funktionalität der Bedieneinrichtung weiterhin erweitert. Bei dieser Ausführungsform wird somit ermöglicht, bestimmte, der Auswerteeinrichtung bekannte Bewegungsabläufe zu erkennen. Diese Bewegungsabläufe können durch die Auswerteeinrichtung einem voraussichtlichen Betätigungswunsch des Betätigungshebels zugeordnet werden und daraus die gewünschte Reaktion hervorrufen. Ein Bewegungsablauf liegt beispielsweise dann vor, wenn eine zeitversetzte Aktivierung von zwei oder mehreren Sensorelementen sowie eine darauf folgende Deaktivierung erkannt werden. So liegt ein Bewegungsablauf zum Beispiel dann vor, wenn die Aktivierung eines ersten Sensorelements zu einem ersten Zeitpunkt und eines zweiten Sensorelements zu einem nachfolgenden zweiten Zeitpunkt erkannt wird und zum zweiten Zeitpunkt das erste Sensorelement wieder als deaktiviert erkannt wird. Als zweiter Zeitpunkt kann hier auch eine kurze Zeitspanne um diesen Zeitpunkt herum verstanden werden. Im Anschluss daran wird zu einem dritten Zeitpunkt ein drittes Sensorelement als aktiviert erkannt, und in einer kurzen Zeitspanne um den dritten Zeitpunkt herum wird das zweite Sensorelement wieder als deaktiviert erkannt, und so weiter und so fort. Entsprechend kann ein Bewegungsablauf jedoch auch so aussehen, dass zu einem ersten Zeitpunkt zumindest zwei unterschiedliche Sensorelemente und zu einem nachfolgenden zweiten Zeitpunkt zumindest zwei andere Sensorelemente als aktiviert erkannt werden.

Der Einsatzbereich bzw. die Funktionalität der Bedieneinrichtung kann auch dadurch erweitert werden, dass die Auswerteeinrichtung eine Zeitdauer der Berührung und/oder der Annäherung erfassen und abhängig von dieser Zeitdauer die Bediengeste erkennen bzw. eine vorbestimmte Funktion auslösen kann. Es ist auch möglich, dass die Auswerteeinrichtung die Zeitdauer zwischen zwei aufeinander folgenden Berührungen und/oder Annäherungen erfasst und abhängig von der Zeitdauer dieser Berührungspause eine vorbestimmte Funktion auslöst. Eine vorbestimmte Funktion kann beispielsweise dann ausgelöst werden, wenn der Benutzer den Betätigungshebel für drei Sekunden berührt und dann nach Ablauf von beispielsweise zwei Sekunden den Betätigungshebel noch einmal an derselben Stelle oder aber an einer anderen Stelle für drei Sekunden berührt.

Die Funktionalität bzw. der Einsatzbereich der Bedieneinrichtung wird dann weiterhin durch die spezielle Anordnung der Sensorelemente erweitert, und zwar durch die ringförmige Anordnung der beabstandet zueinander angeordneten Sensorelemente um den Lenkstockhebel in Umfangsrichtung herum. Somit wird eine neue Bedienart ermöglicht, bei welcher der Benutzer - nämlich insbesondere der Fahrer - eine Drehbewegung zumindest eines Fingers über den Sensorelementen um den Betätigungshebel in Umfangsrichtung herum durchführen und somit verschiedenste Funktionen im Kraftfahrzeug auslösen bzw. verschiedenste Vorgänge bewirken kann. Durch ein solches Streichen des Betätigungshebels in dessen Umfangsrichtung können vorbestimmte Funktionen ausgelöst werden, es kann beispielsweise der aktuelle Wert eines Parameters erhöht bzw. verringert werden, nämlich je nachdem, in welche Richtung die Gleitbewegung um den Betätigungshebel herum vorgenommen wird. Ist der Betätigungshebel ein Lenkstockhebel, so wird eine Multifunktionalität des Lenkstockhebels ermöglicht, sodass der Fahrer mit ein und demselben Lenkstockhebel eine Vielzahl von unterschiedlichsten Funktionen auslösen kann, ohne dass seine Aufmerksamkeit von der Straße abgelenkt wird. Hier kann beispielsweise vorgesehen sein, dass mittels der Sensorelemente ein Scheinwerfer des Kraftfahrzeugs und/oder ein Scheibenwischer und/oder eine Innenraumbeleuchtung und/oder eine Innenraumheizung und/oder eine Scheibenheizung und/oder eine Sitzheizung und/oder eine Sitzverstelleinrichtung und/oder ein Blinker des Kraftfahrzeugs steuerbar ist/sind.

Also sind die Sensorelemente an einem Außenumfang des Betätigungshebels angeordnet. Bevorzugt sind die Sensorelemente äquidistant in Umfangsrichtung des Betätigungshebels verteilt angeordnet. Somit bilden die Sensorelemente insgesamt einen symmetrischen Ring, an welchem verschiedenste Bedienhandlungen vorgenommen werden können.

Die Auswerteeinrichtung kann dazu ausgelegt sein, eine Drehbewegung zumindest eines Fingers des Benutzers über den Sensorelementen um den Betätigungshebel in Umfangsrichtung herum zu detektieren und aufgrund dieser Drehbewegung eine vorbestimmte Funktion auszulösen. Diese Bedienart ist besonders benutzerfreundlich; der Benutzer braucht lediglich mit einem oder mit mehreren Fingern an dem Außenumfang des Betätigungshebels in dessen Umfangsrichtung eine ringförmige Gleitbewegung vorzunehmen, und die Funktion wird sofort ausgelöst. Aufgrund der Drehbewegung kann beispielsweise der aktuelle Wert eines Parameters verändert werden, nämlich insbesondere einer Lautstärke einer Musikanlage des Kraftfahrzeugs und/oder einer Helligkeit eines Leuchtmittels, nämlich beispielsweise einer Innenraumbeleuchtung. Die Veränderung des Parameterwerts ist somit auch ohne Einsatz von verschleißbehafteten Bedienelementen möglich.

In einer Ausführungsform ist vorgesehen, dass die Bedieneinrichtung eine kapazitive Bedieneinrichtung ist und die Sensorelemente als kapazitive Sensorelektroden ausgebildet sind, die jeweils einen Teil eines Betätigungskondensators bilden, dessen Kapazität durch Berührung und/oder Annäherung veränderbar ist. Die Auswerteeinrichtung kann dazu ausgelegt sein, die Veränderung der Kapazitäten der jeweiligen Betätigungskondensatoren zu erfassen und hierdurch die Berührung und/oder die Annäherung zu detektieren. Auf dem kapazitiven Wege gelingt es, die Berührung und/oder Annäherung an die Sensorelemente besonders zuverlässig zu erkennen. Die kapazitive Bedieneinrichtung besitzt außerdem eine besonders gute Empfindlichkeit, sodass jede Berührung bzw. Annäherung erkannt werden kann.

Vorzugsweise ist das zumindest eine Sensorelement mithilfe eines an einem Außenumfang des Betätigungshebels ausgebildeten Strukturelements abgedeckt, nämlich insbesondere einer Mulde oder aber einer Erhebung. Dieses Strukturelement ist dann mit dem zugeordneten Sensorelement in radialer Überlappung angeordnet. Das Strukturelement kann auch aus einer anders ausgeführten, sinnvollerweise durch Finger ertastbaren Oberfläche bestehen, wie etwa einer Riffelung, Narbung oder dergleichen. Beispielsweise kann auch vorgesehen sein, dass die Bedieneinrichtung ein Abdeckelement aufweist, mittels welchem das zumindest eine Sensorelement abgedeckt ist und an dessen Außenumfang das Strukturelement ausgebildet ist. Das Abdeckelement kann beispielsweise in Form einer Hülse oder eines Ringes bereitgestellt sein, welche auf einen Basiskörper des Betätigungshebels aufgesteckt ist. Es ist jedoch grundsätzlich kein Abdeckelement erforderlich, und die Sensorelemente können beispielsweise auch in ein Gehäuse eingespritzt werden oder aber mit einer flexiblen Leiterplatte im Gehäuse oder anderswo im Betätigungshebel untergebracht sein. Der Einsatz eines Strukturelements hat den Vorteil, dass durch die Strukturelemente die Berührungspunkte der Sensorelemente fest vorgegeben sind, sodass der Fahrer bzw. der Benutzer die fest vorgegebenen Berührungsstellen mit seiner Hand ertasten kann, ohne einen Blick auf den Betätigungshebel richten zu müssen.

In einer Ausführungsform ist die Vielzahl von Sensorelementen an einem Bedienelement des Betätigungshebels angeordnet, welches relativ zu einem Grundkörper des Betätigungshebels bewegbar, insbesondere um eine Längsachse des länglichen Betätigungselements drehbar, ist. Auf diese Weise wird eine Multifunktionalität der Bedieneinrichtung im Hinblick auf unterschiedliche Bedienarten ermöglicht. Das Bedienelement kann nämlich mechanisch betätigt werden, und außerdem kann eine Funktion auch alleine durch die Berührung und/oder Annäherung ausgelöst werden. Diese Ausführungsform ermöglicht auch, dass mittels der Auswerteeinrichtung die Absicht des Fahrers erkannt werden kann, das Bedienelement mechanisch zu betätigen. In Abhängigkeit von der Annäherung und/oder Berührung kann die Auswerteeinrichtung nämlich im Voraus bzw. im Vorfeld vorhersagen, dass der Fahrer den Betätigungshebel voraussichtlich mechanisch betätigen wird.

Die Auswerteeinrichtung kann auch dazu ausgelegt sein, abhängig von der Berührung der Sensoranordnung und/oder von der Annäherung an die Sensoranordnung - also abhängig von der erkannten Bediengeste - ein Steuersignal an eine optische Anzeigeeinrichtung des Kraftfahrzeugs - etwa ein Display - abzugeben, aufgrund dessen ein Menü mit einer Vielzahl von dargestellten auswählbaren Menüeinträgen auf der Anzeigeeinrichtung dargestellt wird. Ein solches Menü kann beispielsweise nach Erkennen einer Doppelberührung des Betätigungshebels angezeigt werden, also nach einem zweimaligen Berühren des Betätigungshebels zeitlich kurz hintereinander. Der Fahrer muss somit nicht in aufwändiger Weise nach einem speziellen Knopf für die Aktiviering des Menüs suchen, er kann lediglich den Betätigungshebel - etwa den Lenkstockhebel - (zweimal) berühren, und das Menü wird sofort angezeigt.

Wird das Menü auf der Anzeigeeinrichtung dargestellt, so kann mittels der Sensorelemente einer der angezeigten Menüeinträge ausgewählt und hierbei auf der Anzeigeeinrichtung optisch gegenüber anderen Menüeinträgen hervorgehoben werden. Die Auswahl eines der Menüeinträge kann beispielsweise durch eine Drehbewegung zumindest eines Fingers über den Sensorelementen um den Betätigungshebel in dessen Umfangsrichtung herum erfolgen. Mit ein und demselben Betätigungshebel kann der Benutzer somit sowohl das Menü aktivieren als auch einen der angezeigten Menüeinträge auswählen.

Es erweist sich als besonders vorteilhaft, wenn mittels der Sensorelemente auch die Auswahl des ausgewählten Menüeintrags bestätigt werden kann. Auch hier kann vorgesehen sein, dass die Bestätigung des ausgewählten Menüeintrags durch einen "Doppelklick" erfolgt, also durch zweimaliges Berühren des Betätigungshebels zeitlich kurz hintereinander. Die gesamte Menüführung erfolgt somit mithilfe des Betätigungshebels. Dies ist eine mögliche Reihenfolge:
- Durch eine Doppelberührung wird ein Menü auf der Anzeigeeinrichtung - beispielsweise im Kombiinstrument - mit beeinflussbaren Funktionen bzw. mit einer Vielzahl von Menüeinträgen dargestellt;
- der Fahrer wählt nun durch Drehbewegung bzw. Gleitbewegung an dem Außenumfang des Betätigungshebels die gewünschte Funktion bzw. den gewünschten Menüeintrag aus, nämlich beispielsweise die Helligkeit einer Suchbeleuchtung;
- der Fahrer bestätigt dann die Auswahl der Funktion durch eine Doppelberührung des Betätigungshebels;
- der Fahrer kann nun durch eine weitere Drehbewegung am Betätigungshebel den gewünschten Wert der Helligkeit einstellen; und
- der Fahrer bestätigt schließlich seine Einstellung durch eine erneute Doppelberührung des Betätigungshebels.

Die Auswerteeinrichtung kann auch lernfähig sein: Ist der Betätigungshebel auf zumindest zwei Arten mechanisch betätigbar, so kann die Auswerteeinrichtung dazu ausgelegt sein, bei einer mechanischen Betätigung des Betätigungshebels eine Information über die Art der mechanischen Betätigung zugeordnet zu einer Information über die - insbesondere zeitlich bereits vorangegangenen - Berührung und/oder Annäherung in einer Speichereinrichtung abzuspeichern. Diese Informationen können dann bei einer späteren Bedienung berücksichtigt werden. Die adaptive Auswerteeinrichtung kann sich somit an das Bedienverhalten des Fahrers anpassen und erkennt, welche Handlung des Fahrers üblicherweise nach einer bestimmten Art der Berührung der Sensorelemente erfolgt. Berührt der Fahrer beispielsweise immer vor einer Drückbewegung des Betätigungshebels eine bestimmte Kombination aus zwei oder drei Sensorelementen, kann bei einer einmalig ähnlichen, jedoch nicht eindeutig erkannten Berührung bzw. Sensorkonstellation die Historie als Zusatzinformation berücksichtigt werden. Dies bedeutet, dass die abgespeicherten Informationen beispielsweise dann berücksichtigt werden können, wenn die Auswerteeinrichtung die Berührung und/oder Annäherung nicht eindeutig erkennen kann. Somit kann die Erkennung der Berührung und/oder Annäherung plausibilisiert und die Zuverlässigkeit gesteigert werden.

Die Auswerteeinrichtung kann auch Fahrsituationen berücksichtigen: Die Berührung und/oder Annäherung kann beispielsweise während der Fahrt andere Reaktionen auslösen, als während des Stillstands des Kraftfahrzeugs. Die Auswerteeinrichtung kann also einen Fahrparameter - die Fahrsituation - erfassen und in Abhängigkeit von diesem Fahrparameter sowie in Abhängigkeit von der Berührung und/oder Annäherung eine vorbestimmte Funktion auslösen. Hierbei kann zwischen folgenden Fahrsituationen unterschieden werden: Bremsen und/oder Beschleunigen und/oder Kurvenfahrt und/oder Vorhandenseins eines Objektes im toten Winkel.

Die Auswerteeinrichtung kann auch dazu ausgelegt sein, nach Erkennen einer Berührung und/oder Annäherung ein Rückmeldungssignal auszugeben, mit welchem die Berührung und/oder Annäherung dem Fahrer bestätigt wird. Eine solche kognitive bzw. wahrnehmbare Rückmeldung kann beispielsweise durch einen Piepton und/oder eine Vibration des Betätigungshebels realisiert werden.

Die berührungssensitiven Sensorelemente können auch als Redundanz für mechanische Schalter verwendet werden. Und zwar kann in Abhängigkeit von der Berührung und/oder Annäherung eine Plausibilisierung der mechanischen Betätigung des Betätigungshebels vorgenommen werden.

Insgesamt wird somit eine Bedieneinrichtung bereitgestellt, welche das Aktivieren oder Deaktivieren nahezu beliebiger Funktionen im Kraftfahrzeug sowie das Auslösen unterschiedlichster Funktionen ermöglicht. Eine erste Reaktion kann beispielsweise das Erscheinen eines Menüs in einem Display sein, das über zugewiesene und einstellbare Funktionen informiert. Eine zweite Funktion kann beispielsweise das Aktivieren oder Deaktivieren eines Regensensors sein oder aber das Ein- oder Ausschalten einer Kofferraumbeleuchtung. Eine weitere Reaktion kann das Einstellen einer Sollgröße einer Fahrzeugfunktion sein, wie beispielsweise die Helligkeit der Innenraumbeleuchtung.

Ein erfindungsgemäßes Kraftfahrzeug weist eine erfindungsgemäße Bedieneinrichtung auf. Die mit Bezug auf die erfindungsgemäße Bedieneinrichtung vorgestellten bevorzugten Ausführungsformen und deren Vorteile gelten entsprechend für das erfindungsgemäße Kraftfahrzeug.

Weitere Merkmale der Erfindung ergeben sich aus den Ansprüchen, den Figuren und der Figurenbeschreibung. Alle vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder aber in Alleinstellung verwendbar gemäß den beiliegenden Ansprüchen.

Die Erfindung wird nun anhand eines bevorzugten Ausführungsbeispiels, wie auch unter Bezugnahme auf die beigefügten Zeichnungen näher erläutert.

Es zeigen:
- Fig. 1: in schematischer und perspektivischer Darstellung eine Bedieneinrichtung gemäß einer Ausführungsform der Erfindung;
- Fig. 2: in schematischer und perspektivischer Darstellung die Bedieneinrichtung gemäß Fig. 1, wobei Sensorelemente mit einem Abdeckelement abgedeckt sind; und
- Fig. 3: in schematischer und perspektivischer Darstellung die Bedieneinrichtung mit einem anderen Abdeckelement.

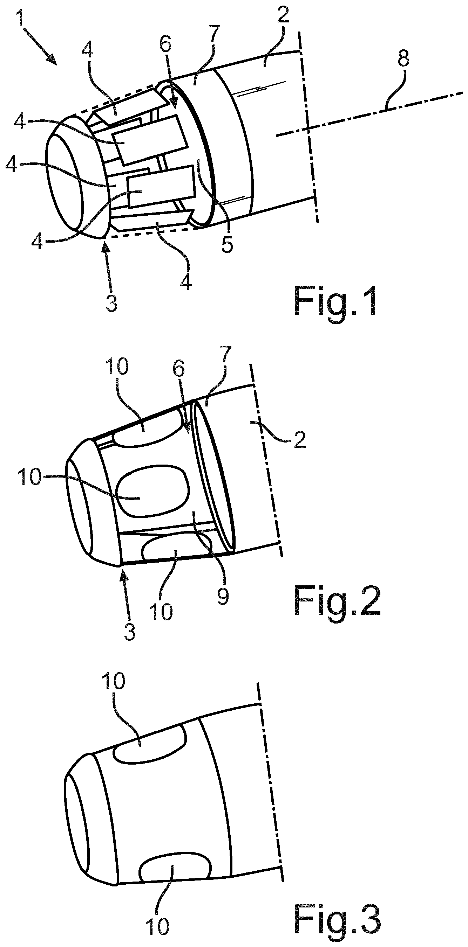

In Fig. 1 ist in schematischer Darstellung eine Bedieneinrichtung 1, und genauer gesagt lediglich Teilkomponenten der Bedieneinrichtung 1, dargestellt. Die Bedieneinrichtung 1 beinhaltet einen Betätigungshebel 2, welcher im Ausführungsbeispiel als Lenkstockhebel eines Lenkstockschalters eines Personenkraftwagens ausgebildet ist. In einem Endbereich 3 des Betätigungshebels 2 sind eine Vielzahl von Sensorelementen 4 angeordnet, welche im Ausführungsbeispiel kapazitive Sensorelektroden sind und insgesamt eine Sensoranordnung bilden. Die Sensorelemente 4 sind jeweils in Form eines dünnen Plättchens aus einem elektrisch leitenden Material - etwa aus Kupfer - ausgebildet und weisen die Form eines länglichen Rechtecks auf. Die Sensorelemente 4 können auch als elektrisch leitfähige Folie ausgeführt sein.

Der Betätigungshebel 2 ist ein länglich ausgeführtes Element mit einem zylinderförmigen Querschnitt, wobei in den Figuren der Übersicht halber lediglich der Endbereich des Betätigungshebels 2 dargestellt ist. Die Sensorelemente 4 sind an einem Außenumfang 5 des Betätigungshebels 2 ringförmig in Umfangsrichtung verteilt angeordnet, sodass sie eine ringförmige Struktur um den Betätigungshebel 2 herum bilden. Hierbei sind die Sensorelemente 4 in Umfangsrichtung äquidistant von einander beabstandet verteilt angeordnet, sodass die Abstände zwischen den jeweiligen benachbarten Sensorelementen 4 in Umfangsrichtung gleich sind. Die einzelnen Sensorelemente 4 sind auch länglich ausgeführt und erstrecken sich in Längsrichtung des Betätigungshebels 2.

Die Sensorelemente 4 sind im Ausführungsbeispiel an einem Endstück 6 angebracht, welches in Richtung zum freien Ende des Betätigungshebels 2 verjüngt ausgebildet ist. Der Durchmesser des Endstücks 6 nimmt somit in Richtung zum freien Ende des Betätigungshebels 2 stetig - und vorzugsweise auch linear - ab. Das Endstück 6 kann auch ein mechanisch betätigbares Bedienelement bilden, welches gegenüber einem Grundkörper 7 des Betätigungshebels 2 bewegbar, insbesondere um die Längsachse 8 des Betätigungshebels 2 drehbar, ist. Alternativ kann es sich bei dem Endstück 6 um ein bezüglich des Grundkörpers 7 ortsfestes Element handeln.

Insgesamt kann die Anzahl der eingesetzten Sensorelemente 4 beispielsweise in einem Wertebereich von eins bis zehn liegen. Es können beispielsweise drei oder vier oder fünf oder sechs oder sieben oder acht oder neun Sensorelemente 4 eingesetzt werden.

Der Betätigungshebel 2 kann auch - in für Lenkstockschalter an sich bekannter Weise - in horizontaler sowie in vertikaler Richtung relativ zu einer Lenksäule des Kraftfahrzeugs verschwenkt werden. Durch diese Schwenkbewegung können im Kraftfahrzeug unterschiedliche Funktionen ausgelöst werden, wie beispielsweise die Aktivierung eines Blinkers, die Aktivierung eines Fernlichts, die Aktivierung eines Scheibenwischers und dergleichen. An dem Betätigungshebel 2 können auch weitere mechanische Bedienelemente angebracht sein, wie beispielsweise Druckknöpfe und/oder Drehknöpfe und/oder Kippschalter und dergleichen. Es kann auch vorgesehen sein, dass der Betätigungshebel 2 in Richtung gegen die Lenksäule gedrückt und/oder in Richtung von der Lenksäule weg gezogen werden kann. Auch somit können unterschiedliche Funktionen aktiviert bzw. deaktiviert werden. Alternativ kann jedoch auch vorgesehen sein, dass der Betätigungshebel 2 mechanisch nicht betätigbar ist und über keine mechanischen Schalter verfügt, so dass alle Bedienfunktionen mittels der Sensorelemente 4 ausgelöst werden können.

Wie in den Fig. 2 und 3 dargestellt ist, können die Sensorelemente mittels eines Abdeckelements 9 abgedeckt sein, an dessen Außenumfang Strukturelemente 10 ausgebildet sein können. Beispielsweise ist jedem Sensorelement 4 ein Strukturelement 10 zugeordnet, welches in Überlappung mit dem jeweiligen Sensorelement 4 angeordnet ist. Es kann aber auch vorgesehen sein, dass - wie beispielsweise in Fig. 3 dargestellt ist - nur einer bestimmten Untermenge bzw. Teilmenge der Sensorelemente 4 jeweils ein Strukturelement 10 zugeordnet ist. Die Strukturelemente 10 können als Mulden oder aber als Erhebungen ausgebildet sein, durch welche die Position der Sensorelemente 4 gekennzeichnet ist. Durch die am Außenumfang des Abdeckelements 9 ausgebildeten Strukturelement 10 sind somit die Berührungsstellen vorgegeben. Der Fahrer kann somit die Berührungsstellen ohne viel Aufwand ertasten und muss dabei keinen Blick auf den Betätigungshebel 2 richten. Das Abdeckelement 9 ist jedoch lediglich optional. Es kann auch vorgesehen sein, dass die Sensorelemente 4 beispielsweise in ein Gehäuse des Betätigungshebels 2 eingespritzt sind.

Die Sensorelemente 4 sind mit einer in den Figuren nicht näher dargestellten Auswerteeinrichtung elektrisch gekoppelt, welche die Änderung der Kapazität der jeweiligen Betätigungskondensatoren aufgrund einer Berührung und/oder Annäherung an die Sensorelemente 4 erfasst. Die elektronische Auswerteeinrichtung kann beispielsweise auch in den Betätigungshebel 2 integriert oder aber in einem Lenkstockschalter oder in einem anderen Steuergerät in dessen Umgebung angeordnet sein. Durch die Erfassung der Kapazitätsänderung kann die Auswerteeinrichtung die Berührung der einzelnen Sensorelemente 4 (selbstverständlich über das Abdeckelement 9) und/oder die Annäherung an die einzelnen Sensorelemente 4 detektieren. Die Auswerteeinrichtung kann im Ausführungsbeispiel unterschiedliche Bedienarten detektieren:
Zum einen kann die Auswerteeinrichtung eine ringförmige Gleitbewegung eines oder mehrerer Finger um das Endstück 6 in Umfangsrichtung herum detektieren. Mit anderen Worten kann die Auswerteeinrichtung einen zeitlichen Verlauf der Betätigung der Sensorelemente 4 erkennen und in Abhängigkeit davon eine vorbestimmte Funktion im Kraftfahrzeug auslösen. Eine ringförmige Gleitbewegung der Finger um das Endstück 6 herum kann beispielsweise dazu führen, dass der aktuelle Sollwert eines Betriebsparameters des Kraftfahrzeugs verändert wird. Durch eine solche Bedienart kann beispielsweise die Lautstärke und/oder die Helligkeit eines Leuchtmittels eingestellt werden.

Ergänzend oder alternativ kann die Auswerteeinrichtung auch eine Reihenfolge der Berührung der einzelnen Sensorelemente 4 bzw. der Annäherung an die einzelnen Sensorelemente 4 erfassen und in Abhängigkeit von der erfassten Reihenfolge eine vorbestimmte Funktion im Kraftfahrzeug auslösen. Diese Bedienart kann beispielsweise dazu genutzt werden, um unterschiedlichste Funktionalitäten im Kraftfahrzeug zu aktivieren oder aber zu deaktivieren. Beispielsweise kann durch Berührung jedes zweiten Sensorelements 4 ein Regensensor aktiviert oder deaktiviert werden.

Das Berühren eines der Sensorelemente 4 kann auch dazu führen, dass ein Menü auf einem Display des Kraftfahrzeugs angezeigt wird. Zum Anzeigen des Menüs kann der Fahrer beispielsweise eine zweifache Berührung eines der Sensorelemente 4 kurz hintereinander vornehmen, sodass nach einem solchen "Doppelklick" das Menü sofort erscheint. Dieses Menü kann eine Vielzahl von auswählbaren Menüeinträgen aufweisen, welche separat voneinander ausgewählt werden können. Zum Auswählen eines der dargestellten Menüeinträge kann der Fahrer die gleitende Drehbewegung um das Endstück 6 herum ausführen, sodass während dieses Streichens an dem Außenumfang 5 die Menüeinträge einer nach dem anderen optisch hervorgehoben werden. Nach Auswahl eines der Menüeinträge kann diese Auswahl auch mit einem "Doppelklick" an dem Außenumfang 5 bestätigt werden.

Weitere Bedienarten können sein:
- Die Auswerteeinrichtung kann auch eine Zeitdauer der Berührung und/oder der Annäherung erfassen und abhängig von dieser Zeitdauer eine vorbestimmte Funktion auslösen;
- die Auswerteeinrichtung kann auch die Berührung einer vorbestimmten Kombination aus einzelnen Sensorelementen 4 und/oder die Annäherung an diese Kombination der Sensorelemente 4 erfassen und abhängig von der Kombination eine vorbestimmte Funktion auslösen.

Ganz allgemein ist die Auswerteeinrichtung also so eingerichtet, dass sie anhand der erkannten Berührung der Sensorelemente 4 und/oder der Annäherung an selbige Sensorelemente 4 eine Bediengeste der Bedienperson an dem Betätigungshebel 2 erkennen kann, also die Art und Weise, wie der Fahrer den Betätigungshebel 2 umgreift.

Wie bereits ausgeführt, kann der Betätigungshebel 2 auch mechanische Bedienelemente aufweisen, etwa das um die Längsachse 8 drehbare Endstück 6. Auch der Betätigungshebel 2 alleine kann um die Fahrzeuglängsachse sowie um die Fahrzeughochachse geschwenkt werden, um unterschiedliche Funktionen zu aktivieren. Allgemein gesagt, kann der Betätigungshebel 2 auf zumindest zwei Arten mechanisch betätigt werden. In diesem Falle kann die Auswerteeinrichtung in Abhängigkeit von der erkannten Bediengeste die Art der bevorstehenden Betätigung des Betätigungshebels 2 im Vorfeld vorhersagen. Dies bedeutet, dass die Auswerteeinrichtung abhängig von der Berührung und/oder Annäherung die voraussichtliche Art der mechanischen Betätigung bestimmen kann, noch bevor der Fahrer diese mechanische Betätigung ausführt. Die Annäherung an die unteren bzw. dem Boden zugewandten Sensorelemente 4 bedeutet beispielsweise in der Regel, dass der Betätigungshebel 2 in vertikaler Richtung nach oben verschwenkt werden wird. Diese Information kann beispielsweise dazu genutzt werden, um die Schaltsignale der mechanischen Schalter und somit die Detektion der mechanischen Betätigung zu plausibilisieren. Abhängig von der erkannten Absicht des Fahrers kann auch zumindest ein Fahrerassistenzsystem aktiviert werden. So kann zum Beispiel die Erkennung einer beabsichtigten Betätigung eines Blinkers eine Totwinkelüberwachungseinrichtung aktivieren, mittels welcher der Fahrer vor im Totwinkel befindlichen Objekten gewarnt wird. Diese Totwinkelüberwachungseinrichtung bracht hingegen nach Erkennen einer beabsichtigten Aktivierung des Fernlichts/Lichthupe nicht aktiviert zu werden. Es ist auch möglich, nach Erkennen der Absicht, die Empfindlichkeit eines Regensensors oder aber eine Intervallgeschwindigkeit eines Scheibenwischers zu ändern, ein Regensensormenü bzw. ein Intervallmenü auf einem Display zu aktivieren. Dieses Menü braucht hingegen nach Erkennen der Absicht des Ein- oder Ausschaltens des Scheibenwischers nicht aktiviert zu werden.

Ist der Betätigungshebel 2 auf zumindest zwei Arten mechanisch betätigbar, so kann die Auswerteeinrichtung auch bei einer mechanischen Betätigung des Betätigungshebels 2 die Information über die Art der mechanischen Betätigung zugeordnet zu einer Information über die Berührung und/oder Annäherung in einer Speichereinrichtung abspeichern. Es wird somit durch die Auswerteeinrichtung gelernt, welche Sensorelemente 4 bei welcher Art der mechanischen Betätigung berührt werden. Die Auswerteeinrichtung kann also erkennen, welche mechanische Handlung des Fahrers üblicherweise nach einer bestimmten Art der Berührung der berührungssensitiven Sensorelemente 4 erfolgt. Diese abgelegten Informationen können dazu genutzt werden, um eine spätere Berührung und/oder Annäherung zu plausibilisieren. Betätigt der Fahrer beispielsweise immer ein bestimmtes Sensorelement 4, bevor er den Betätigungshebel 2 entlang seiner Längsachse 8 drückt, so kann bei einer späteren ähnlichen, aber nicht eindeutig erkannten Berührung die abgelegte Information berücksichtigt und die erkannte Berührung plausibilisiert werden.

## Patentansprüche

1. Berührungs- und/oder annäherungssensitive Bedieneinrichtung (1) für ein Kraftfahrzeug, mit:
- einem länglich ausgeführten Betätigungshebel (2), insbesondere einem Lenkstockhebel,
- einer Sensoranordnung umfassend eine Vielzahl von berührungs- und/oder annäherungssensitiven Sensorelementen (4), welche an dem Betätigungshebel (2) angeordnet sind, und
- einer mit der Vielzahl von Sensorelementen (4) gekoppelten elektronischen Auswerteeinrichtung, welche dazu ausgelegt ist, eine Berührung der einzelnen Sensorelemente (4) und/oder eine Annäherung an die einzelnen Sensorelemente (4) zu erfassen, wobei die Auswerteeinrichtung dazu ausgelegt ist, anhand einer Kombination aus zumindest zwei erfassten Berührungen der Sensoranordnung und/oder Annäherungen an die Sensoranordnung eine Bediengeste einer Bedienperson an dem Betätigungshebel (2) zu erkennen und in Abhängigkeit von der erkannten Bediengeste eine vorbestimmte Bedienfunktion auszulösen,
und wobei die berührungs- und/oder annäherungssensitiven Sensorelemente (4) ringförmig in Umfangsrichtung des Betätigungshebels (2) verteilt angeordnet sind.

2. Bedieneinrichtung (1) nach Anspruch 1,
**dadurch gekennzeichnet, dass**
der Betätigungshebel (2) auf zumindest zwei Arten mechanisch bedienbar ist und die Auswerteeinrichtung dazu ausgelegt ist, in Abhängig von der detektierten Bediengeste die Art einer beabsichtigten mechanischen Bedienung des Betätigungshebels (2) im Voraus zu bestimmen.

3. Bedieneinrichtung (1) nach Anspruch 2,
**dadurch gekennzeichnet, dass**
die Auswerteeinrichtung dazu ausgelegt ist, nach Erkennen der Art der beabsichtigten mechanischen Bedienung eine von einer dieser Art der mechanischen Bedienung zugeordneten Bedienfunktion verschiedene Bedienfunktion auszulösen, insbesondere ein Fahrerassistenzsystem und/oder eine vorbestimmte Anzeige auf einer Anzeigeeinrichtung zu aktivieren.

4. Bedieneinrichtung (1) nach einem der vorhergehenden Ansprüche,
**dadurch gekennzeichnet, dass**
die Auswerteeinrichtung dazu ausgelegt ist, anhand einer Kombination aus zumindest zwei erfassten Berührungen unterschiedlicher Sensorelemente (4) und/oder Annäherungen an unterschiedliche Sensorelemente (4) die Bediengeste zu erkennen.

5. Bedieneinrichtung (1) nach Anspruch 4,
**dadurch gekennzeichnet, dass**
die Auswerteeinrichtung dazu ausgelegt ist, die gleichzeitige Berührung einer vorbestimmten Kombination aus einzelnen Sensorelementen (4) und/oder die gleichzeitige Annäherung an diese Kombination der Sensorelemente (4) zu erfassen und abhängig davon die Bediengeste zu erkennen.

6. Bedieneinrichtung (1) nach Anspruch 4 oder 5,
**dadurch gekennzeichnet, dass**
die Auswerteeinrichtung dazu ausgelegt ist, eine zeitliche Reihenfolge der Berührung der einzelnen Sensorelemente (4) und/oder Annäherung an die einzelnen Sensorelemente (4) zu erfassen und in Abhängig von der Reihenfolge die Bediengeste zu erkennen.

7. Bedieneinrichtung (1) nach einem der vorhergehenden Ansprüche,
**dadurch gekennzeichnet, dass**
die Auswerteeinrichtung dazu ausgelegt ist, eine Zeitdauer der Berührung und/oder der Annäherung zu erfassen und abhängig von der Zeitdauer die Bediengeste zu erkennen.

8. Bedieneinrichtung (1) nach Anspruch 1,
**dadurch gekennzeichnet, dass**
die Auswerteeinrichtung dazu ausgelegt ist, eine Drehbewegung zumindest eines Fingers des Benutzers über den Sensorelementen (4) um den Betätigungshebel (2) in Umfangsrichtung herum zu erkennen und aufgrund dieser Drehbewegung eine vorbestimmte Funktion auszulösen.

9. Bedieneinrichtung (1) nach Anspruch 8,
**dadurch gekennzeichnet, dass**
die Auswerteeinrichtung dazu ausgelegt ist, aufgrund der Drehbewegung den aktuellen Wert eines Parameters zu verändern, insbesondere:
- einer Lautstärke und/oder
- einer Helligkeit eines Leuchtmittels.

10. Bedieneinrichtung (1) nach einem der vorhergehenden Ansprüche,
**dadurch gekennzeichnet, dass**
die Bedieneinrichtung (1) eine kapazitive Bedieneinrichtung (1) ist und die einzelnen Sensorelemente (4) als kapazitive Sensorelektroden ausgebildet sind, die ein Teil eines Betätigungskondensators bilden, dessen Kapazität durch Berührung und/oder Annäherung veränderbar ist, wobei die Auswerteeinrichtung dazu ausgelegt ist, die Veränderung der Kapazität des Betätigungskondensators zu erfassen und hierdurch die Berührung und/oder Annäherung zu erkennen.

11. Bedieneinrichtung (1) nach einem der vorhergehenden Ansprüche,
**dadurch gekennzeichnet, dass**
die Vielzahl von Sensorelementen (4) an einem Bedienelement (6) des Betätigungshebels (2) angeordnet ist, welches relativ zu einem Grundkörper (7) des Betätigungshebels (2) bewegbar, insbesondere um eine Längsachse (8) des länglichen Betätigungshebels (2) drehbar, ist.

12. Bedieneinrichtung (1) nach einem der vorhergehenden Ansprüche,
**dadurch gekennzeichnet, dass**
die Auswerteeinrichtung dazu ausgelegt ist, abhängig von der erkannten Bediengeste ein Steuersignal an eine optische Anzeigeeinrichtung abzugeben, aufgrund dessen ein Menü mit einer Vielzahl von auswählbaren Menüeinträgen auf der Anzeigeeinrichtung darstellbar ist.

13. Bedieneinrichtung (1) nach Anspruch 13,
**dadurch gekennzeichnet, dass**
mittels der einzelnen Sensorelemente (4), insbesondere durch eine Drehbewegung zumindest eines Fingers über den Sensorelementen (4) um den Betätigungshebel (2) in dessen Umfangsrichtung herum, einer der angezeigten Menüeinträge auswählbar und hierbei auf der Anzeigeeinrichtung optisch hervorhebbar ist.

14. Bedieneinrichtung (1) nach Anspruch 13 oder 14,
**dadurch gekennzeichnet, dass**
mittels der Sensoranordnung die Auswahl eines ausgewählten Menüeintrags bestätigbar ist.

15. Bedieneinrichtung (1) nach einem der vorhergehenden Ansprüche,
**dadurch gekennzeichnet, dass**
der Betätigungshebel (2) auf zumindest zwei Arten mechanisch bedienbar ist und die Auswerteeinrichtung dazu ausgelegt ist, bei einer mechanischen Betätigung des Betätigungshebels (2) eine Information über die Art der mechanischen Bedienung zugeordnet zu einer Information über die erkannte Bediengeste in einer Speichereinrichtung abzuspeichern.

16. Kraftfahrzeug mit einer Bedieneinrichtung (1) nach einem der vorhergehenden Ansprüche.

## Claims

1. Touch-sensitive and/or proximity-sensitive operating device (1) for a motor vehicle, having:
- an actuation lever (2), in particular a steering column stalk, which has an elongate configuration,
- a sensor arrangement comprising a multiplicity of touch-sensitive and/or proximity-sensitive sensor elements (4) which are arranged on the actuation lever (2), and
- an electronic evaluation device which is coupled to the multiplicity of sensor elements (4) and is configured to detect the individual sensor elements (4) being touched and/or the individual sensor elements (4) being approached,
wherein the evaluation device is configured to identify an operating gesture of an operator on the actuation lever (2) on the basis of a combination of at least two detected touches on the sensor arrangement and/or approaches towards the sensor arrangement, and to trigger a predetermined operating function on the basis of the identified operating gesture,
and wherein the touch-sensitive and/or proximity-sensitive sensor elements (4) are arranged so as to be distributed annularly in the circumferential direction of the actuation lever (2).

2. Operating device (1) according to Claim 1, **characterized in that**
the actuation lever (2) is mechanically actuable in at least two manners and the evaluation device is configured to determine in advance, on the basis of the detected operating gesture, the manner of an intended mechanical operation of the actuation lever (2).

3. Operating device (1) according to Claim 2, **characterized in that**
the evaluation device is configured, once the manner of the intended mechanical operation has been identified, to trigger an operating function which is different from an operating function associated with said manner of mechanical operation, in particular to activate a driver assistance system and/or a predetermined display on a display device.

4. Operating device (1) according to one of the preceding claims, **characterized in that**
the evaluation device is configured to identify the operating gesture on the basis of a combination of at least two detected touches of different sensor elements (4) and/or approaches towards different sensor elements (4).

5. Operating device (1) according to Claim 4, **characterized in that**
the evaluation device is configured to detect a predetermined combination of individual sensor elements (4) being touched at the same time and/or said predetermined combination of the sensor elements (4) being approached at the same time and to identify the operating gesture on the basis of this.

6. Operating device (1) according to Claim 4 or 5, **characterized in that**
the evaluation device is configured to detect a temporal sequence of touches on the individual sensor elements (4) and/or approaches towards the individual sensor elements (4) and to identify the operating gesture on the basis of the sequence.

7. Operating device (1) according to one of the preceding claims, **characterized in that**
the evaluation device is configured to detect a duration of the touch and/or the proximity and to identify the operating gesture on the basis of the duration.

8. Operating device (1) according to Claim 1, **characterized in that**
the evaluation device is configured to identify a rotational movement of at least one finger of the user over the sensor elements (4) around the actuation lever (2) in the circumferential direction and to trigger a predetermined function owing to said rotational movement.

9. Operating device (1) according to Claim 8, **characterized in that**
the evaluation device is configured to change the present value of a parameter owing to the rotational movement, said parameter being in particular:
- a volume and/or
- a brightness of an illuminant.

10. Operating device (1) according to one of the preceding claims, **characterized in that**
the operating device (1) is a capacitive operating device (1) and the individual sensor elements (4) are designed as capacitive sensor electrodes which form a part of an actuation capacitor the capacitance of which is variable by touch and/or approach, wherein the evaluation device is configured to detect the change in the capacitance of the actuation capacitor and, as a result of this, to identify the touch and/or approach.

11. Operating device (1) according to one of the preceding claims, **characterized in that**
the multiplicity of sensor elements (4) is arranged on an operating element (6) of the actuation lever (2), which operating element is moveable relative to a main body (7) of the actuation lever (2), in particular is rotatable about a longitudinal axis (8) of the elongate actuation lever (2).

12. Operating device (1) according to one of the preceding claims, **characterized in that**
the evaluation device is configured to output, on the basis of the identified operating gesture, a control signal to an optical display device, as a result of which control signal a menu with a multiplicity of selectable menu entries can be displayed on the display device.

13. Operating device (1) according to Claim 13, **characterized in that**,
by means of the individual sensor elements (4), in particular by a rotational movement of at least one finger over the sensor elements (4) around the actuation lever (2) in the circumferential direction thereof, one of the displayed menu entries is selectable and, in this connection, is optically highlightable on the display device.

14. Operating device (1) according to Claim 13 or 14, **characterized in that**
the selection of a selected menu entry can be confirmed by means of the sensor arrangement.

15. Operating device (1) according to one of the preceding claims, **characterized in that**
the actuation lever (2) is mechanically operable in at least two manners and the evaluation device is configured to store an item of information relating to the manner of the mechanical operation associated with an item of information relating to the identified operating gesture in a memory device when the actuation lever (2) is mechanically actuated.

16. Motor vehicle having an operating device (1) according to one of the preceding claims.

## Revendications

1. Dispositif de commande (1) sensible au toucher et/ou à l'approche pour un véhicule automobile, comprenant :
- un levier d'actionnement (2) réalisé allongé, notamment un levier de colonne de direction,
- un arrangement de détection comprenant une pluralité d'éléments de détection (4) sensibles au toucher et/ou à l'approche qui sont disposés au niveau du levier d'actionnement (2) et
- un dispositif d'interprétation électronique connecté à la pluralité d'éléments de détection (4), lequel est conçu pour détecter un toucher des éléments de détection (4) individuels et/ou une approche vers les éléments de détection (4) individuels,
le dispositif d'interprétation étant conçu, à l'aide d'une combinaison d'au moins deux touchers détectés de l'arrangement de détection et/ou approches vers l'arrangement de détection, pour reconnaître un geste de commande d'un opérateur au niveau du levier d'actionnement (2) et déclencher une fonction de commande prédéterminée en fonction du geste de commande reconnu, et les éléments de détection (4) sensibles au toucher et/ou à l'approche étant disposés distribués en forme d'anneau dans la direction circonférentielle du levier d'actionnement (2) .

2. Dispositif de commande (1) selon la revendication 1, **caractérisé en ce que** le levier d'actionnement (2) peut être commandé mécaniquement sur au moins deux types et le dispositif d'interprétation est conçu pour déterminer à l'avance le type d'une commande mécanique envisagée du levier d'actionnement (2) en fonction du geste de commande détecté.

3. Dispositif de commande (1) selon la revendication 2, **caractérisé en ce que** le dispositif d'interprétation est conçu pour, après avoir reconnu le type de la commande mécanique envisagée, déclencher une fonction de commande différente d'une fonction de commande associée à ce type de la commande mécanique, notamment activer un système d'assistance au conducteur et/ou une indication prédéterminée sur un dispositif d'affichage.

4. Dispositif de commande (1) selon l'une des revendications précédentes, **caractérisé en ce que** le dispositif d'interprétation est conçu pour reconnaître le geste de commande à l'aide d'une combinaison d'au moins deux touchers détectés d'éléments de détection (4) différents et/ou approches vers des éléments de détection (4) différents.

5. Dispositif de commande (1) selon la revendication 4, **caractérisé en ce que** le dispositif d'interprétation est conçu pour détecter le toucher simultané d'une combinaison prédéterminée d'éléments de détection (4) individuels et/ou l'approche simultanée vers cette combinaison d'éléments de détection (4) individuels et reconnaître le geste de commande en fonction de celui-ci/celle-ci.

6. Dispositif de commande (1) selon la revendication 4 ou 5, **caractérisé en ce que** le dispositif d'interprétation est conçu pour détecter un ordre chronologique du toucher des éléments de détection (4) individuels et/ou de l'approche vers les éléments de détection (4) individuels et reconnaître le geste de commande en fonction de celui-ci.

7. Dispositif de commande (1) selon l'une des revendications précédentes, **caractérisé en ce que** le dispositif d'interprétation est conçu pour détecter une durée du toucher et/ou de l'approche et reconnaître le geste de commande en fonction de celle-ci.

8. Dispositif de commande (1) selon la revendication 1, **caractérisé en ce que** le dispositif d'interprétation est conçu pour reconnaître un mouvement de rotation d'au moins un doigt de l'utilisateur au-dessus des éléments de détection (4) autour du levier d'actionnement (2) dans la direction circonférentielle et déclencher une fonction prédéterminée sur la base de ce mouvement de rotation.

9. Dispositif de commande (1) selon la revendication 8, **caractérisé en ce que** le dispositif d'interprétation est conçu pour modifier la valeur actuelle d'un paramètre sur la base du mouvement de rotation, notamment :
- un volume sonore et/ou
- une luminosité d'un moyen lumineux.

10. Dispositif de commande (1) selon l'une des revendications précédentes, **caractérisé en ce que** le dispositif de commande (1) et un dispositif de commande (1) capacitif et les éléments de détection (4) individuels sont réalisés sous la forme d'électrodes de détection capacitives qui forment une partie d'un condensateur d'actionnement dont la capacité est modifiée par le toucher et/ou l'approche, le dispositif d'interprétation étant conçu pour détecter la modification de la capacité du condensateur d'actionnement et reconnaître ainsi le toucher et/ou l'approche.

11. Dispositif de commande (1) selon l'une des revendications précédentes, **caractérisé en ce que** la pluralité d'éléments de détection (4) sont disposés au niveau d'un élément de commande (6) du levier d'actionnement (2), lequel peut être déplacé par rapport à un corps de base (7) du levier d'actionnement (2), notamment effectuer une rotation autour d'un axe longitudinal (8) du levier d'actionnement (2) allongé.

12. Dispositif de commande (1) selon l'une des revendications précédentes, **caractérisé en ce que** le dispositif d'interprétation est conçu pour délivrer un signal de contrôle à un dispositif d'affichage visuel en fonction du geste de commande détecté, sur la base duquel un menu comprenant une pluralité de lignes de menu pouvant être sélectionnées peut être représenté sur le dispositif d'affichage.

13. Dispositif de commande (1) selon la revendication 13, **caractérisé en ce que** l'une des lignes de menu affichées peut être sélectionnée et ainsi mise en valeur visuellement sur le dispositif d'affichage au moyen des éléments de détection individuels (4), notamment par un mouvement de rotation d'au moins un doigt au-dessus des éléments de détection (4) autour du levier d'actionnement (2) dans sa direction circonférentielle.

14. Dispositif de commande (1) selon la revendication 13 ou 14, **caractérisé en ce que** la sélection d'une ligne de mesure sélectionnée peut être confirmée au moyen de l'arrangement de détection.

15. Dispositif de commande (1) selon l'une des revendications précédentes, **caractérisé en ce que** le levier d'actionnement (2) peut être commandé mécaniquement sur au moins deux types et le dispositif d'interprétation est conçu pour, lors d'un actionnement mécanique du levier d'actionnement (2), mémoriser dans un dispositif de mémoire une information à propos du type de la commande mécanique associée à une information à propos du geste de commande reconnu.

16. Véhicule automobile comprenant un dispositif de commande (1) selon l'une des revendications précédentes.
